Europäisches Patentamt

European Patent Office

Office européen des brevets

(11) Numéro de publication: **0 330 589**
**A1**

## DEMANDE DE BREVET EUROPEEN

(21) Numéro de dépôt: 89420059.1

(22) Date de dépôt: 17.02.89

(51) Int. Cl.⁴: **H 01 L 21/00**

(30) Priorité: 26.02.88 FR 8802888

(43) Date de publication de la demande:
30.08.89 Bulletin 89/35

(84) Etats contractants désignés:
AT BE CH DE ES GB GR IT LI LU NL SE

(71) Demandeur: **CENTRE STEPHANOIS DE RECHERCHES MECANIQUES HYDROMECANIQUE ET FROTTEMENT Société dite:**
**Zone Industrielle Sud Rue Benoît Fourneyron**
**F-42160 Andrezieux Boutheon (FR)**

(72) Inventeur: **Champet, Gérard**
**Les Echauds**
**F-42170 Saint Just Saint Rambert (FR)**

**Charpille, Gilles**
**12 Rue Raisin**
**F-42000 Saint Etienne (FR)**

(74) Mandataire: **Dupuis, François**
**Cabinet Charras 3 Place de l'Hôtel-de-Ville BP 203**
**F-42005 St. Etienne Cédex 1 (FR)**

(54) **Dispositif pour le transfert d'articles d'au moins un organe support à au moins un autre organe support.**

(57) Le dispositif est remarquable en ce que lesdits moyens (1) sont indépendants en étant asservis chacun par un système d'organes (10)-(9) assujettis à un moyen de commande en étant aptes à assurer le déplacement relatif des moyens de préhension (1) les uns par rapport aux autres afin de faire varier leur pas d'une manière continue pour mettre leur écartement en correspondance avec celui des encoches où les articles doivent être transférés, l'ensemble des moyens de préhension étant montés sur une platine support déplaçable en translation et en hauteur.

FIG.1

EP 0 330 589 A1

Bundesdruckerei Berlin

## Description

**Dispositif pour le transfert d'articles d'au moins un organe support à au moins un autre organe support.**

L'invention concerne plus particulièrement, mais non limitativement, le transfert des plaquettes de silicium, d'un panier à une nacelle, et inversement. En effet, les plaquettes ou autres, en phase de traitement sont positionnées verticalement dans des encoches que présente un panier, lesdites encoches étant toutes décalées d'un même espacement.

Avant d'enfourner ces plaquettes dans un four à diffusion par exemple, il est nécessaire de les tranférer dans une nacelle généralement réalisée en matériau réfractaire. D'une manière connue, une nacelle présente des encoches latérales pour maintenir verticalement les plaquettes d'une manière régulière et ordonnées, mais avec un pas ou espacement différent de celui du panier.

Cette opération de transfert est délicate. Outre le fait qu'il convient de veiller à éviter toute contamination des plaquettes par dépôt de particules étrangères, il est nécessaire de tenir compte, dans le mesure de possible, de cette différence de pas, c'est-à-dire d'espacement entre les encoches du panier et de la nacelle.

Dans ces conditions, le transfert des plaquettes du panier à la nacelle et inversement, s'opère très souvent d'une manière unitaire, avec des moyens appropriés. On conçoit que cela n'est pas rationnel et inadapté dans un procédé de traitement automatique des plaquettes par exemple.

Le problème posé est donc de pouvoir assurer la préhension de l'ensemble ou d'un certain nombre déterminé, des plaquettes contenues dans le panier (ou dans la nacelle), puis d'assurer le transfert de l'ensemble ou du nombre déterminé des plaquettes saisies dans la nacelle (ou dans le panier) en tenant compte de la variation de pas qui existe entre le panier et la nacelle.

Pour résoudre ce problème, le demandeur a proposé une solution comme il ressort dU brevet EP 0.228.973 dont il est titulaire. Pour l'essentiel, ce brevet enseigne un dispositif qui comprend plusieurs moyens de préhension coopérant avec l'ensemble des plaquettes ou autres articles. Ces moyens de préhension sont par example fixés aux extrémités d'une spire interrompue de tubes creux hélicoïdaux solidaires d'organes support, assujettis à des systèmes d'entraînement reliés à des moteurs électriques.

Une telle solution est relativement délicate à mettre en oeuvre sur un plan industriel et ne donne pas entièrement satisfaction. En outre, de par la conception des moyens de mise en oeuvre, des risques de contamination des plaquettes peuvent se produire.

Pour remédier à ces inconvénients et résoudre le problème posé de variation de pas lors du transfert des plaquettes ou autres articles, d'une manière simple, efficace et rationnelle, sans risque de contamination, l'invention propose une solution qui met en oeuvre un dispositif remarquable en ce que lesdits moyens de préhension sont indépendants en étant asservis chacun par un système d'organes assujettis à un moyen de commande en étant aptes à assurer le déplacement relatif des moyens de préhension les uns par rapport aux autres afin de faire varier leur pas d'une manière continue pour mettre leur écartement en correspondance avec celui des encoches où les articles doivent être transférés, l'ensemble des moyens de préhension et du système de variation de pas étant montés sur une platine support déplaçable en translation et en hauteur et située sous les organes supports.

Avantageusement, le problème posé est résolu par les caractéristiques suivantes :
- le système d'organes est composé par des pignons étagés coopérant avec des éléments faisant office de crémaillère,
- chaque moyen de préhension est relié à un pignon par un élément faisant office de crémaillère de sorte que pour chaque moyen correspond un pignon de diamètre et de denture différents pour permettre, lors de l'entraînement en rotation des pignons étagés, un déplacement différent en translation des moyens de préhension pour correspondre à la variation de pas souhaitée,
- chacun des moyens de préhension à l'exception de celui situé à l'une des extrémités de l'ensemble constitué par lesdits moyens, est relié à un chariot indépendant monté avec capacité de déplacement en translation sur une partie de la platine support, chacun desdits chariots étant accoupé à un pignon par l'intermédiaire de l'élément faisant office de crémaillère,
- les diamètres primitifs Dp des différents pignons étagés, pour chacun des moyens de préhension numérotés de 2 à n sont les suivants :
* pour le moyen de préhension n° 2 : $Dp2 = M2\ Z2$
* pour le moyen de préhension n° 3 : $Dp3 = Dp2 +$ constante
* pour le moyen de préhension n° n : $Dpn = Dpn - 1 +$ constante

M étant le module de la denture du pignon et de la crémaillère correspondante, tandis que Z est le nombre de dents des pignons,
- les pignons étagés sont montés sur un arbre commun entraîné en rotation, dans un sens ou dans l'autre, par un moteur programmable du type axe numérique.

Pour donner une fiabilité maximum au dispositif, il est apparu nécessaire de contrôler l'un des organes support, notamment la nacelle au niveau plus particulièrement du pas des encoches, du positionnement de la première encoche et de la déformation de la nacelle.

Le problème posé est résolu au moyen du détecteur de proximité monté sur un bras horizontal notamment lié à une table de guidage par un organe apte à assurer le réglage en hauteur desdits détecteurs, lesquels sont assujettis à un moyen de commande pour être déplacés le long de la nacelle.

D'autres caractéristiques ressortiront de la suite de la description.

L'invention est exposée ci-après plus en détail à l'aide des dessins annexés dans lesquels

- la figure 1 est une vue de face du dispositif,

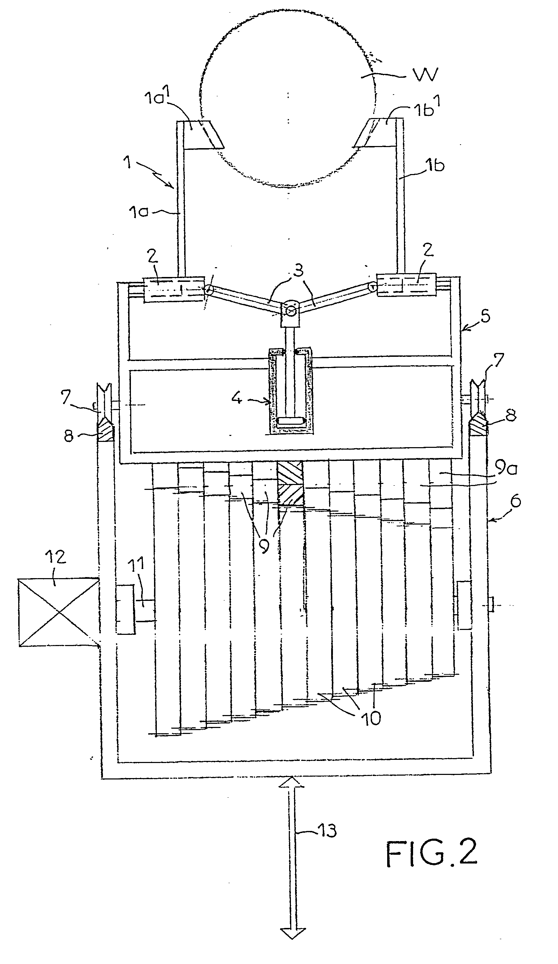

- la figure 2 est une vue de côté correspondant à la figure 1,
- les figures 3, 4, 5 et 6 sont des vues à caractère purement schématique montrant le principe du transfert selon l'invention.

Comme indiqué, le dispositif est particulièrement bien adapté pour le transfert des plaquettes de silicium ou wafers (w) d'au moins un panier (P) à au moins une nacelle (N), sans pour cela exclure le transfert d'autres articles avec une variation de pas en cours de transfert.

Dans ces conditions, le dispositif peut être monté sur tout type de machine connue comprenant par exemple, et essentiellement, un barillet supportant les paniers avec notamment un poste de chargement/déchargement des paniers, un poste pour l'orientation des méplats des wafers, un poste de chargement ou déchargement des wafers du panier, un manipulateur pour assurer le transfert des wafers du barillet à un poste de préhension et inversement, ces postes étant aptes à être équipés du dispositif de transfert. Cette machine pour le traitement des plaquettes n'est pas décrite en détail car elle ne fait pas partie de l'objet spécifique de l'invention.

Le dispositif comprend plusieurs moyens de préhension indépendants aptes à coopérer simultanément avec la totalité des plaquettes positionnées dans un panier ou nacelle, ou avec une partie seulement de la totalité desdites plaquettes. A titre indicatif, les moyens de préhension sont au nombre de treize avec la possibilité de prendre indépendamment de 1 à 13 plaquettes.

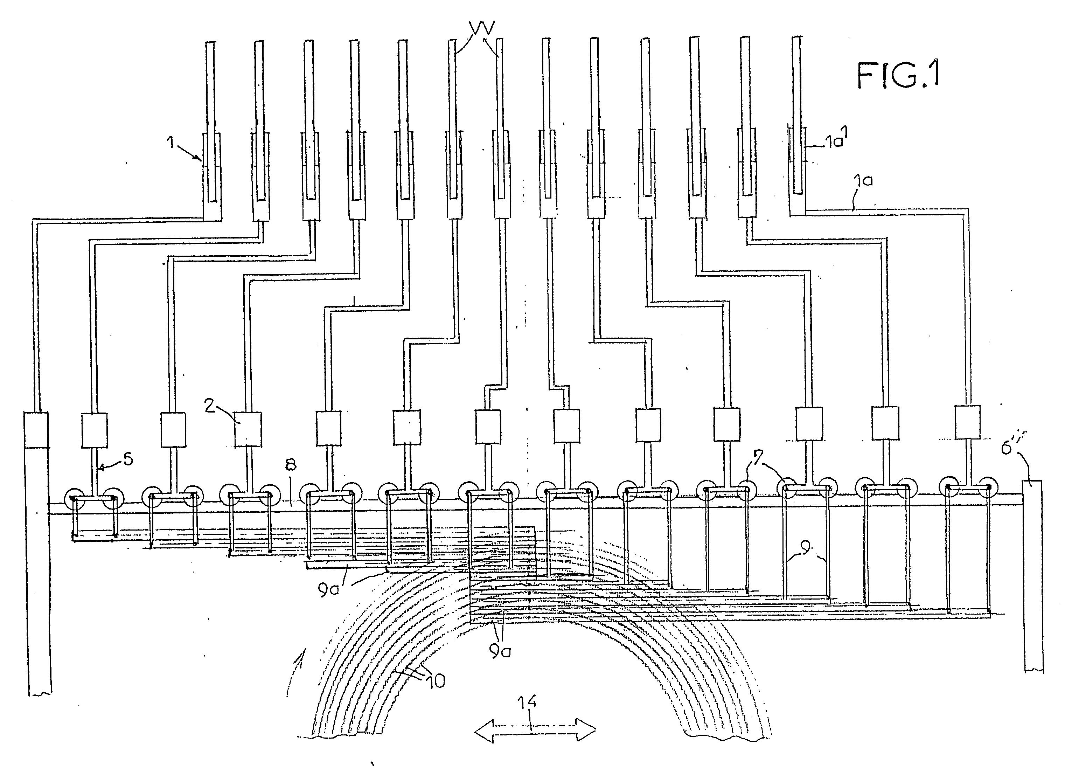

Comme le montre la figure 1, chaque moyens de préhension est composé d'une pince (1) comprenant deux branches profilées (1a) et (1b), disposées en regard et coopérant chacune à leur base avec un organe de guidage (2) assujetti à un système de biellettes (3) commandé par un vérin (4) ou autre organe de manoeuvre pour permettre le rapprochement ou l'éloignement des deux branches correspondant à la position d'ouverture ou de fermeture de la pince. L'extrémité des branches (1a) et (1b) présente des embouts (1a1)-(1b1), en téflon, polypropylène et autres, dans lesquels est pratiquée une entaille pour guider les wafers lors de leur prise par la tranche.

A noter que l'ouverture des branches (1a) et (1b) s'opère par mise en action du vérin, ou autre organe de manoeuvre tandis que la fermeture desdites branches peut être assurée par un ressort.

Selon l'invention, d'une manière importante, chacune des pinces (1) ainsi définie, est reliée au niveau de sa partie inférieure à un chariot indépendant (5), monté avec capacité de déplacement guidé en translation sur une platine support (6). Par exemple, chaque chariot (5) support de pince (1) présente des organes de roulement (7) coopérant avec des rails de guidage parallèles (8) que présente une partie de la platine (6).

A noter que la pince (1-1) considérée à l'une des extrémités de l'ensemble des moyens de préhension, est montée sur la platine support (6) avec une position fixe en translation. Compte-tenu du montage de chacune des pinces (1) (à l'exception de la pince (1-1)) sur des chariots indépendants (5), lesdites pinces peuvent être déplacées en translation sur la platine (6) les unes par rapport aux autres pour faire varier en conséquence leur écartement.

Dans ce but, chacun des chariots support de pince est relié par l'intermédiaire d'une barre (9) faisant office de crémaillère (9a) à un pignon denté (10). Pour chaque pince (1) correspond un pignon de diamètre et de denture différents de sorte que sous l'effet d'entraînement en rotation des pignons étagés ainsi définis, il en résulte un déplacement concomitant en translation différent des chariots support de pince pour correspondre à la variation de pas souhaité.

Les pignons étagés (10) sont montés centrés sur des roulements à billes étanches portés par un arbre (11) asservi directement ou par l'intermédiaire d'un système de transmission par poulies et courroies crantées notamment, à un moteur de commande (12) programmable, du type axe numérique Infranor, pour entraîner lesdits pignons, dans un sens ou dans l'autre, selon un déplacement angulaire déterminé. Les pignons (10) et crémaillères correspondantes (9a) sont à denture droite.

Ces ensembles pignons-crémaillères sont déterminés de la façon suivante, étant rappelé que la première pince (1-1) est fixe en translation de sorte qu'elle n'est pas assujettie à un ensemble pignon-crémaillère par l'intermédiaire d'un chariot.

Si M est le module de la denture du pignon et de la crémaillère, Z le nombre de dents du pignon et Dp le diamètre primitif du pignon, pour chacune des pinces numérotées de 2 à n, le diamètre primitif du pignon correspondant sera :
* pour la pince n° 2 : $Dp2 = M2 \, Z2$
* pour la pince n° 3 : $Dp3 = Dp2 +$ constante
* pour la pince n° 4 : $Dp4 = Dp3 +$ constante
* pour la pince n° n : $Dpn = Dpn-1 +$ constante.

Si le dispositif comprend, comme indiqué 13 pinces, les pignons (10) et crémaillères (9a) seront au nombre de 12.

Pour permettre de réaliser les différents mouvements nécessaires au transport des plaquettes, la platine support (6) est asservie par des moyens de commande, pour être déplacée verticalement en translation.

Par example, le mouvement vertical symbolisé par la flèche (13) est assuré par un ensemble moteur à courant continu, transmission à poulies et courroie crantées et vis à billes pour permettre le déplacement en hauteur des wafers soit pour leur sortie des encoches d'un peigne ou de la nacelle, soit pour passer au-dessus des wafers déjà en place (cas des tests ou des baffles).

Ces déplacement en hauteur sont contrôlés par des capteurs inductifs avec une précision qui n'est pas nécessairement rigoureuse.

Le mouvement longitudinal de translation symbolisé par la flèche (14) est assuré par un moteur à courant continu, une transmission à poulies et courroie crantées et vis à billes pour permettre le chargement d'une nacelle à partir d'un peigne ou le déchargement vers le peigne. Tous ces mouvements longitudinaux devront être réalisés avec une très grande précision.

Des capteurs inductifs placés à chaque extrémité de la platine support (6) serviront de sécurité.

La partie fixe de l'ensemble de la platine (6) à mouvements croisés est montée par example sur le châssis support-barillet.

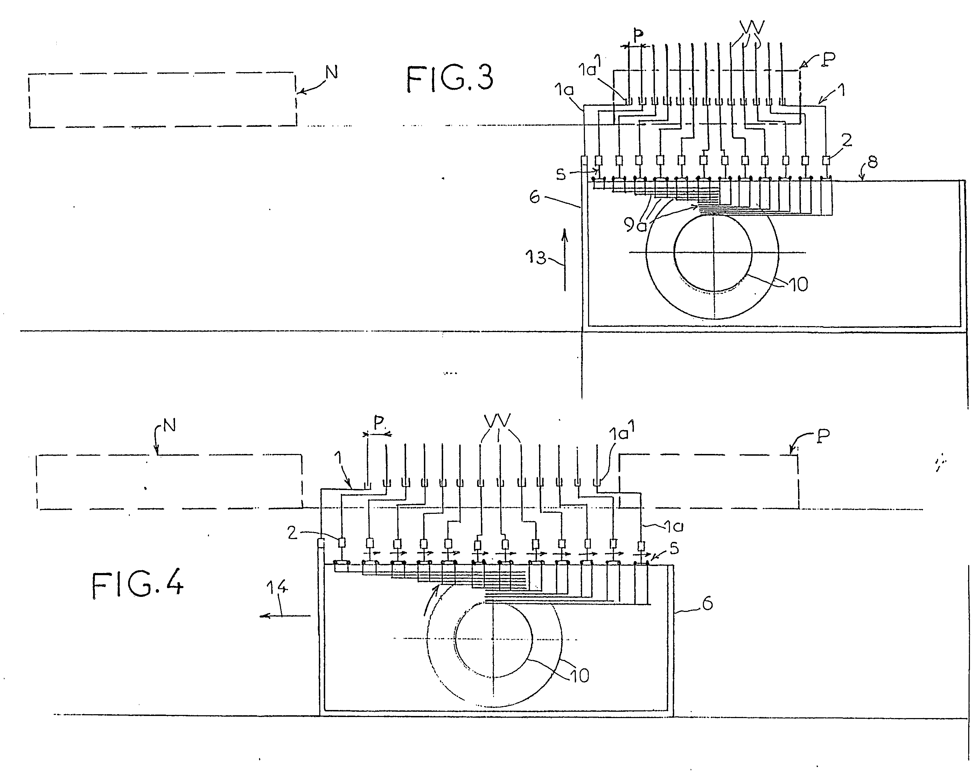

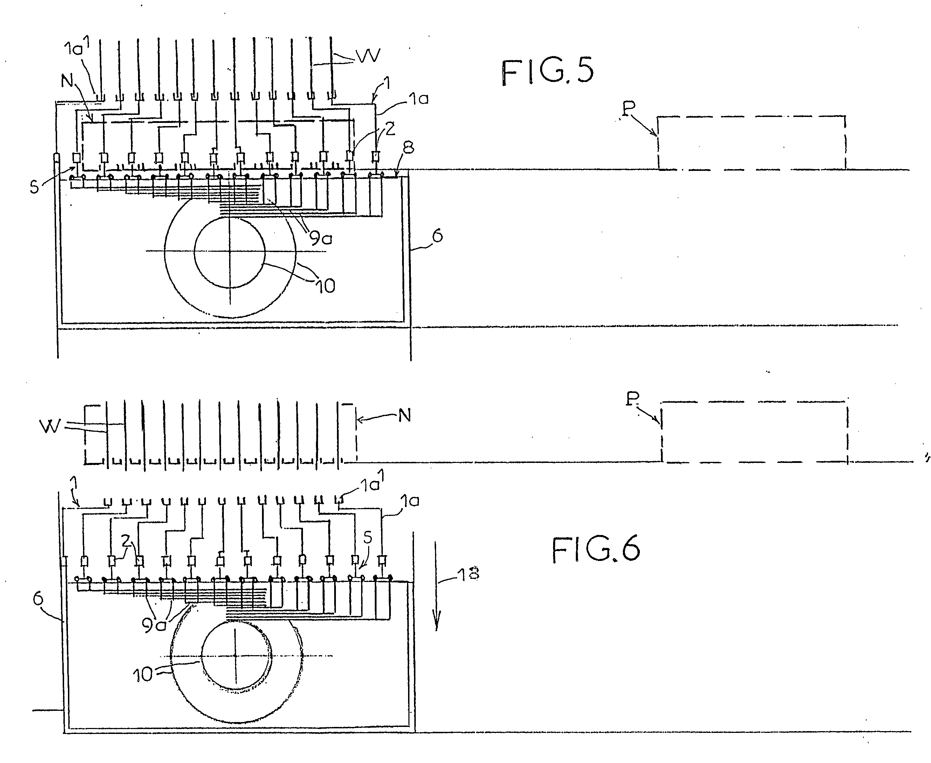

Le fonctionnement du dispositif est le suivant, étant souligné que le cycle décrit est donné seulement à titre d'exemple indicatif :
- déplacement en hauteur de la platine support (6) et par conséquent de l'ensemble des éléments de préhension (pince (1) - chariot (5) - crémaillère (9) - pignon (10)), pour saisir un nombre déterminé et programmé de plaquettes (W) positionnées verticalement dans un panier (P) (ou une nacelle N). Les pinces correspondantes sont commandées en conséquence pour assurer la préhension (figure 3) ;
- déplacement en translation de la platine (6) avec l'ensemble des éléments de préhension ((1)-(5)-(9)-(10)) en direction de la nacelle (N) (ou des paniers (P)), pour assurer le transfert des plaquettes saisies (N). Pendant cette opération de transfert, le moteur de commande (12) des pignons étagés (10) est entraîné en rotation, dans un sens ou dans l'autre, pour provoquer, par déplacement des crémaillères (9a) auxquelles sont assujetties les pinces (1), la contraction ou la dilatation selon le cas, du pas (P) des placquettes saisies, et cela d'une façon continue (figure 4) ;
- positionnement de la platine (6) et de l'ensemble des éléments de préhension au-dessus de la nacelle (N) (ou du panier (P)) en position d'alignement vertical des plaquettes (W) et des encoches de ladite nacelle (ou dadit panier) (figure 5) ;
- descente de la platine (6) et de l'ensemble des éléments de préhension par rapport à la nacelle (N) (ou panier) pour permettre le positionnement des plaquettes de ladite nacelle (ou dadit panier) (figure 6).

Comme indiqué, pour donner une fiabilité maximum au dispositif, il est apparu important de contrôler l'un des organes support, notamment la nacelle (N), au niveau plus particulièrement du pas des encoches, du positionnement de la première encoche et de la déformation de la nacelle.

Dans ce but, deux capteurs, notamment du type opto-électroniques à faisceau focalisé sont montés sur un bras horizontal lié à une table de guidage par un organe apte à assurer le réglage en hauteur desdits capteurs. En outre, ces deux capteurs sont asservis par un moteur-réducteur continu à deux sens de marche pour être déplacés parallèlement par rapport à la nacelle, notamment au niveau des encoches des barreaux supérieurs de ladite nacelle.

De plus, un capteur indicatif permet de connaître le nombre de tours du moteur de déplacement du capteur opto-électronique.

Ces différentes informations captées sont rentrées dans un moyen de comptage pour être traitées et comparées à des éléments de référence pour indiquer à l'opérateur si la nacelle ainsi contrôlée est bonne ou pas.

Les avantages ressortent bien de la description.

## Revendications

- 1 - Dispositif pour le transfert d'articles d'au moins un organe support (P) à au moins un autre organe support (W), chacun desdits supports ayant des encoches au autres pour le positionnement vertical notamment des articles, les encoches du premier support et les encoches du deuxième support ayant un écartement différent, le dispositif qui comprend plusieurs moyens de préhension (1) aptes à coopérer simultanément avec les articles en vue de les saisir en totalité ou en partie, est caractérisé en ce que lesdits moyens de préhension (1) sont indépendants en étant asservis chacun par un système d'organes (5)-(10)-(9) assujettis à un moyen de commande en étant aptes à assurer le déplacement relatif des moyens de préhension (1) les uns par rapport aux autres afin de faire varier leur pas d'une manière continue pour mettre leur écartement en correspondance avec celui des encoches où les articles doivent être transférés, l'ensemble des moyens de préhension et du système de variation de pas (5)-(10)-(9) étant montés sur une platine support déplaçable en translation et en hauteur et située sous les organes supports (P) - (W).

- 2 - Dispositif selon la revendication 1, caractérisé en ce que le système d'organes est composé par des pignons étagés (10) coopérant avec des éléments faisant office de crémaillère (9).

- 3 - Dispositif selon la revendication 2, caractérisé en ce que chaque moyen de préhension (1) est relié à un pignon (10) par un élément faisant office de crémaillère de sorte que pour chaque moyen (1) correspond un pignon (10) de diamètre et de denture différents pour permettre, lors de l'entraînement en rotation des pignons étagés, un déplacement différent en translation des moyens de préhension pour correspondre à la variation de pas souhaitée.

- 4 - Dispositif selon la revendication 3, caractérisé en ce que chacun des moyens de préhension (1) à l'exception de celui situé à l'une des extrémités de l'ensemble constitué par lesdits moyens, est relié à un chariot indépendant (5) monté avec capacité de déplacement en translation sur une partie de la platine support (6), chacun desdits chariots étant accoupé à un pignon par l'intermédiaire de l'élément faisant office de crémaillère.

- 5 - Dispositif selon la revendication 4, caractérisé en ce que le moyen de préhension, situé à l'une des extrémités de l'ensemble constitué par lesdits moyens de préhension, est monté sur la platine support (6) avec une partie fixe en translation.

- 6 - Dispositif selon l'une quelconque des revendications 3 et 4, caractérisé en ce que les diamètres primitifs Dp des différents pignons étagés (10), pour chacun des moyens de préhension numérotés de 2 à n sont les suivants :

\* pour le moyen de préhension n° 2 : $Dp2 = M2$ $Z2$

\* pour le moyen de préhension n° 3 : $Dp3 = Dp2 + constante$

\* pour le moyen de préhension n° n : $Dpn = Dpn - 1 + constante$

M étant le module de la denture du pignon et de la crémaillère correspondante, tandis que Z est le nombre de dents des pignons.

- 7 - Dispositif selon l'une quelconque des revendications 1 et 2, caractérisé en ce que les pignons étagés (10) sont montés sur un arbre commun (11) entraîné en rotation, dans un sens ou dans l'autre, par un moteur programmable du type axe numérique (12).

- 8 - Dispositif selon l'une quelconque des revendications 1, 2 et 5, caractérisé en ce que les pignons et crémaillères (10)(9) sont à dentures droites.

- 9 - Dispositif selon la revendication 1, caractérisé en ce que chaque moyen de préhension est composé d'une pince (1) comprenant deux branches profilées (1a) et (1b) disposées en regard et coopérant chacune avec un organe de guidage (2) assujetti à un système de commande (3) (4) apte à assurer le rapprochement ou l'éloignement desdites branches, l'extrémité libre de chacune des branches étant agencée pour coopérer avec l'article à saisir.

- 10 - Dispositif selon la revendication 1, caractérisé en ce que l'un des organes support recevant les articles est contrôlé par des organes aptes à déterminer le pas des encoches, le positionnement de la première encoche et la déformation dudit support.

- 11 - Dispositif selon la revendication 10, caractérisé en ce que les organes de contrôle comprenant des détecteurs de proximité montés sur un bras horizontal lié à une table de guidage par un moyen apte à assurer le réglage en hauteur desdits détecteurs, lesquels sont assujettis à un moyen de commande pour être déplacés parallèlement au support à contrôler.

FIG.1

EP 0 330 589 A1

FIG.2

FIG.3

FIG.4

FIG.5

FIG.6

EP 0 330 589 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4 ) |
|---|---|---|---|
| X,D | EP-A-0228973 (CENTRE STEPHANOIS DE RECHERCHES MECAN. HYDROMECANIQUE ET FROTTEMENT)<br>* colonne 5, ligne 3 – colonne 7, ligne 19 * | 1 | H01L21/00 |
| A | * colonne 8, ligne 54 – ligne 60; figures 8-11 *<br>----- | 9, 10 | |

**DOMAINES TECHNIQUES RECHERCHES (Int. Cl.4 )**

H01L

**Le présent rapport a été établi pour toutes les revendications**

| Lieu de la recherche | Date d'achèvement de la recherche | Examinateur |
|---|---|---|
| LA HAYE | 02 MAI 1989 | LOMMEL A. |